Europäisches Patentamt

European Patent Office

Office européen des brevets

(19)

(11) **EP 0 794 619 A2**

(12) **EUROPÄISCHE PATENTANMELDUNG**

(43) Veröffentlichungstag:
    **10.09.1997 Patentblatt 1997/37**

(51) Int. Cl.$^6$: **H03K 17/687**

(21) Anmeldenummer: **97103744.5**

(22) Anmeldetag: **06.03.1997**

(84) Benannte Vertragsstaaten:
    **DE FR GB IT**

(30) Priorität: **08.03.1996 DE 19609121**

(71) Anmelder: **SIEMENS AKTIENGESELLSCHAFT**
    **80333 München (DE)**

(72) Erfinder:
    • **Wachter, Franz, Dipl.-Ing.**
      **9504 Villach (AT)**
    • **Zitta, Heinz, Dipl.-Ing.**
      **9580 Drobollach (AT)**
    • **Massoner, Johann, Dipl.-Ing.**
      **9500 Villach (AT)**

(54) **Schaltungsanordnung zum Ansteuern eines Feldeffekttransistors mit sourceseitiger Last**

(57)     Die erfindungsgemäße Schaltungsanordnung zur Ansteuerung eines Feldeffekttransistors mit sourceseitiger Last weist eine Kapazität auf, die einerseits über die Laststrecke des Feldeffekttransistors mit der Versorgungsspannung und andererseits mit einer Ladeeinrichtung sowie steuerbaren Schaltmitteln verbunden ist, wobei die Schaltmittel zwischen der Kapazität und dem Gateanschluß des Feldeffekttransistors geschaltet sind. Erfindungsgemäß ist eine zweite Ladeeinrichtung vorgesehen, die über zweite steuerbare Schaltmittel die Gate-Source-Kapazität des Feldeffekttransistors aufladen. Des weiteren ist ein Komparator vorgesehen, der die Spannung am Gate des Feldeffekttransistors überwacht und bei Erreichen eines vorbestimmten Wertes die ersten Steuermittel leitend schaltet.

FIG 1

EP 0 794 619 A2

**Beschreibung**

Die Erfindung bezieht sich auf eine Schaltungsanordnung zum Ansteuern eines Feldeffekttransistors gemäß dem Oberbegriff des Anspruchs 1.

Eine derartige Schaltungsanordnung ist z.B. aus EP 04 05 407 A2 bekannt. Bei einem derartigen als Schalter ausgebildeten Feldeffekttransistor liegt der Drainanschluß an der positiven Betriebsspannung. Da als Treibertransistoren nur n-Kanal-Feldeffekttransistoren eingesetzt werden können, ist beim Einschalten eine künstliche Gate-Spannungserhöhung über die Drainspannung notwendig, damit der Transistor in den verlustarmen $R_{on}$-Bereich gelangt, wobei gilt: $U_{DS} < U_{GS}-U_T$. Des weiteren sind bei derartigen Anordnungen relativ hohe Schaltgeschwindigkeiten und eine möglichst einfache Schaltung mit geringem Flächenaufwand gefordert.

Zur Erreichung einer erhöhten Spannung sind z.B. sogenannte Ladungspumpen bekannt, bei der die erhöhte Betriebsspannung grundsätzlich durch ein Umschalten mehrerer Kapazitäten von parallel (Ladephase) in seriell (Umlade- bzw. Entladephase) erreicht wird. Eine derartige Ladungspumpenschaltung ist jedoch aufwendig und benötigt bei Integration eine relativ große Fläche. Aus diesem Grund wird häufig für derartige Anwendungen das sogenannte „Bootstrap"-Prinzip angewendet, welches jedoch nur dynamisch funktioniert.

In Figur 1 der EP 04 05 407 A2 ist eine derartige Bootstrap-Schaltung dargestellt. Die Kapazität 4 wird anfänglich über die Versorgungsspannungsklemme 1 und die Diode 3 auf die Betriebsspannung aufgeladen und im Einschaltaugenblick über den Schalter 5 an das Gate des Feldeffekttransistors 2 gelegt. Der Drainstrom beginnt dann zu fließen und durch den Spannungsabfall am Lastwiderstand 10 wird das Gate „hochgepumpt". Der Leistungstransistor 2 gelangt so in den linearen Arbeitsbereich.

Um den Ladungsausgleich und die sich stationär einstellende Gatespannung berechnen zu können, wird vorausgesetzt, daß die Spannung am Kondensator gleich der Versorgungsspannung ist. Dann gilt:

$$U_{GS} = \frac{U_{DD} + \frac{C_{GS}}{C_H} U_{GSO}}{1 + \frac{C_{GS}}{C_H}} . \tag{1}$$

Setzt man nun voraus, daß im ausgeschalteten Zustand die Spannung am Gate-Sourcekondensator gleich Null ist, so ergibt sich für die Gate-Sourcespannung $U_{GS}$ im eingeschwungenen Zustand, d.h. wenn der Schalter geschlossen ist in Abhängigkeit von der Gate-Source-Kapazität $C_{GS}$ und der Kapazität C die Gleichung:

$$U_{GS} = \frac{U_{DD}}{1 + \frac{C_{GS}}{CH}} \tag{2}$$

Diese Spannung reicht aus, wenn in diskreten Schaltkreisen große Hilfskondensatoren eingesetzt werden können bzw. wenn $C > C_{GS}$ ist. Da die Gate-Source-Kapazität integrierter Leistungstransistoren im allgemeinen sehr groß ist, kann dieses Prinzip kaum mit vertretbarem Flächenaufwand verwirklicht werden.

Aufgabe der vorliegenden Erfindung ist es daher, eine Schaltungsanordnung anzugeben, die die vorgenannten Nachteile nicht aufweist.

Diese Aufgabe wird durch den kennzeichnenden Teil des Anspruchs 1 gelöst. Die Merkmale der Unteransprüche kennzeichnen vorteilhafte Weiterbildungen der Erfindung.

Aus Gleichung (1) ist ersichtlich, daß zur Minimierung des Flächenaufwandes der Term $U_{GS0}C_{GS}C_H$ auszunützen ist. Das heißt, daß vor dem eigentlichen Ladungsausgleich die Gate-Source-Kapazität eine möglichst große Anfangsladung $Q_{GS0} > 0$ aufweisen sollte. Diese Forderung wird erfindungsgemäß durch die zusätzliche Ladeeinrichtung erfüllt. Sobald die Spannung am Gate des Feldeffekttransistors einen vorgegebenen Wert erreicht hat, kann der Schalter aktiviert werden und der Ladungsausgleich zwischen dem Bootstrap-Kondensator und der Gate-Source-Kapazität erfolgen.

Diese zusätzliche Ladeeinrichtung kann vorteilhafterweise durch eine steuerbare Stromquelle und eine in Reihe geschaltete Diode ausgebildet sein.

Damit vor dem Einschaltvorgang die Gate-Source-Kapazität vollständig entladen ist, kann zusätzlich vorteilhafterweise eine weitere steuerbare Stromquelle vorgesehen sein, die mit dem invertierten Ansteuersignal angesteuert wird, so daß im ausgeschalteten Zustand die Gate-Source-Kapazität entladen wird.

Eine besonders vorteilhafte und einfache Realisierung des Komparators kann durch einen Spannungsstromwandler mit angekoppelten Stromspiegel realisiert werden.

Um eine höhere Schaltgeschwindigkeit zu erreichen, kann vorteilhafterweise ein weiteres Schaltelement dazu benutzt werden, die Bootstrap-Kapazität mit der Versorgungsspannung zu beaufschlagen. Ein weiterer Vorteil einer derartigen Ausführungsform besteht darin, daß der Spannungssprung zu einem definierten Zeitpunkt erfolgt.

Diese Schaltmittel können vorzugsweise durch das Ausgangssignal des Stromspiegels des Komparators angesteuert werden.

Durch eine weitere steuerbare Stromquelle kann der Bootstrap-Kondensator immer auf einen definierten Bezugspegel vor dem Einschalten des Feldeffekttransistors gelegt werden.

Durch eine einfache Weiterbildung der erfindungsgemäßen Schaltung kann auch ein statischer Betrieb gewährleistet werden. Die Erweiterung besteht in einer kleinen Ladungspumpe, die erst später zugeschaltet wird, was verhindert, daß sich die Gates der Leistungstransistoren über Diodenrestströme entladen.

Die Erfindung wird nachfolgend anhand von drei Figuren näher erläutert.

Es zeigen

Figur 1     ein Prinzipschaltbild der Laderegelung,
Figur 2     ein Ausführungsbeispiel der in Figur 1 gezeigten erfindungsgemäßen Schaltungsanordnung und
Figur 3     einen Signallaufplan von bestimmten Spannungen und Strömen der Schaltungsanordnung gemäß Figur 2.

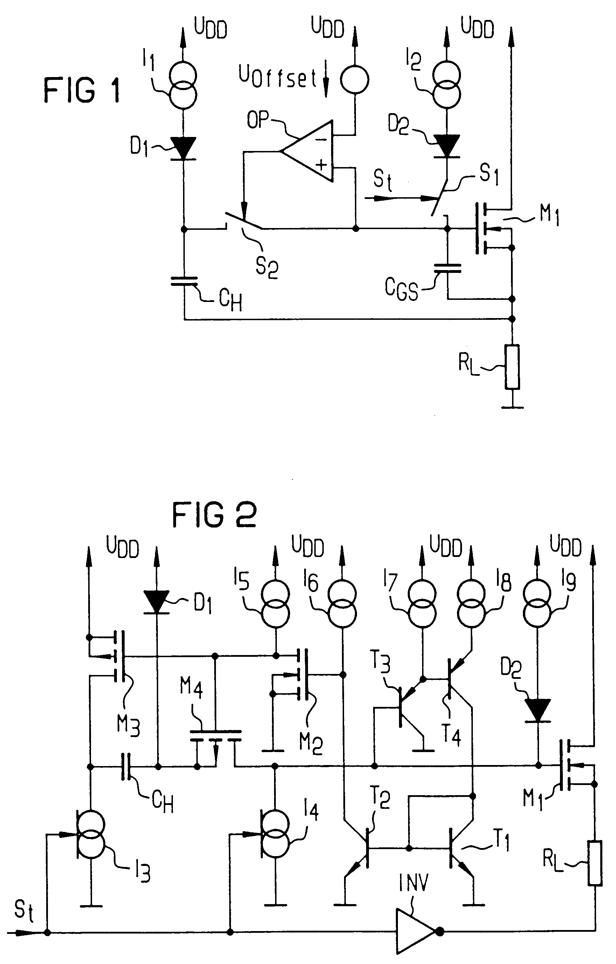

In Figur 1 ist der Feldeffektleistungstransistor mit M1 bezeichnet und dessen Drainanschluß ist mit der Versorgungsspannung $U_{DD}$ beaufschlagt und dessen Sourceanschluß über den Widerstand $R_L$ mit Masse verbunden. $C_{GS}$ bezeichnet die Gate-Source-Kapazität des Leistungs-MOSFET M1. Zwischen dem Gate des Transistors M1 und der Versorgungsspannungsklemme $U_{DD}$ befindet sich die Reihenschaltung aus einem steuerbaren Schalter S1 einer Diode D2 und einer Stromquelle I2. Der Steuerbare Schalter S1 wird über ein Steuersignal St angesteuert. Das Gate des Transistors M1 ist des weiteren über einen weiteren steuerbaren Schalter S2 mit dem ersten Anschluß der Kapazität $C_H$ verbunden. Der andere Anschluß der Kapazität $C_H$ ist mit dem Sourceanschluß des Transistors M1 verschaltet. Eine weitere Reihenschaltung aus einer Stromquelle $I_1$ und einer Diode D1 ist zwischen die Versorgungsspannungsklemme $U_{DD}$ und dem ersten Anschluß der Kapazität $C_H$ geschaltet. Der steuerbare Schalter S2 wird von dem Ausgangssignal eines als Komparator geschalteten Operationsverstärkers OP angesteuert, dessen invertierender Eingang über eine Hilfsspannungsquelle $U_{offset}$ mit der Versorgungsspannungsklemme $U_{DD}$ verbunden ist. Der nichtinvertierende Eingang ist mit dem Gateanschluß des Transistors M1 verbunden.

Wird durch ein entsprechendes Steuersignal der Schalter S1 geschlossen, so wird die Stromquelle I2 aktiviert und die Gate-Source-Kapazität $C_{GS}$ lädt sich über den Lastwiderstand $R_L$ auf. Da der Transistor M1 nun im Sättigungsbereich arbeitet und sein Drainstrom einen Spannungsabfall am Lastwiderstand $R_L$ verursacht, liegt die maximale Gate-Source-Anfangsspannung $U_{GS0}$ betragsmäßig unter der Betriebsspannung $U_{DD}$. Für den stabilen Zustand nach dem Zuschalten der Stromquelle I2 gilt mit $I(C_{GS}) = 0$ und der jeweiligen Transistorkennlinie im Sättigungsbereich

$$I_D \;=\; I_{RL} \;=\; \frac{\beta}{2}\,(U_{GS}-U_{Tn})^2 \qquad\qquad (3)$$

der Ansatz

$$U_{DD} \;=\; U_{GS0} \;+\; \frac{\beta R_L}{2}\,(U_{GS0}-U_{Tn})^2 \qquad\qquad (4)$$

mit der Lösung

$$U_{GS0_{1,2}} = U_{Th} - \frac{1}{\beta R_L} \;\pm\; \frac{1}{\beta R_L}\sqrt{1+2\beta R_L(U_{DD}-U_{Tn})}\;. \qquad (5)$$

Da für einen endlichen Drainstrom $U_{GS0} \geq U_{tn}$ sein muß, reduziert sich diese Gleichung zu

$$U_{GS0} \;=\; U_{tn} \;+\; \frac{1}{\beta R_L}\sqrt{1+2\beta R_L(U_{DD}-U_{Tn})}-1) \;. \tag{6}$$

Darin ist $R_L$ der Lastwiderstand, $\beta$ der Verstärkungsfaktor und $U_{Tn}$ die Schwellspannung des MOS-Transistors M1. Erst wenn die oben dargestellte Vorladung als abgeschlossen betrachtet werden kann und das Gate-Potential annähernd der Betriebsspannung $U_{DD}$ ist, wird von dem als Komparator dienenden Operationsverstärker OP der Ladungsausgleich eingeleitet. Zu diesem Zweck ist es notwendig, einen definierten Komparatorschaltpunkt bereitzustellen. Hierzu wird über die Hilfsspannungsquelle $U_{offset}$ eine Referenzspannung erzeugt, die durch Subtraktion von der Versorgungsspannung $U_{DD}$ etwas kleiner als diese ist. Somit stellt sich nach Schließen des Schalters S2 die Gate-Source-Spannung

$$U_{GS} \;=\; \frac{U_{DD}+\dfrac{C_{GS}}{C_H}U_{GSO}}{1+\dfrac{C_{GS}}{C_H}} \tag{7}$$

ein.

In Figur 2 ist ein Ausführungsbeispiel einer derartigen erfindungsgemäßen Anordnung näher dargestellt. Gleiche Elemente zeigen gleiche Bezugszeichen. Anstelle des Schalters S1 wird hier eine steuerbare Stromquelle I9 verwendet. Diese wird vom Ausgangssignal eines Inverters INV angesteuert, dessen Eingang mit dem Steuersignal St beaufschlagt wird. Der Schalter S2 ist hier durch einen MOSFET-Transistor M4 realisiert. Der zweite Anschluß der Kapazität $C_H$ ist hier zum einen über die Laststrecke eines weiteren MOSFET M3 mit der Versorgungsspannungsklemme $U_{DD}$ und zum anderen über eine weitere steuerbare Stromquelle I3 mit Masse verbunden. Die steuerbare Stromquelle I3 wird vom Steuersignal St angesteuert. Eine weitere steuerbare Stromquelle I4 ist vorgesehen, die zwischen Gateanschluß des MOSFET M1 und Masse geschaltet ist und ebenfalls durch das Steuersignal St angesteuert wird. Der Komparator wird durch Bipolartransistoren T1 bis T4 und die Stromquellen I5 bis I8 sowie den Ausgangs-MOSFET M2 gebildet. Der Basisanschluß des pnp-Transistors T3 ist mit dem Gateanschluß des Transistors M1 verbunden. Der Kollektor des Transistors T3 ist mit Masse verschaltet und sein Emitter ist zum einen mit der Basis des pnp-Transistors T4 und über die Stromquelle I7 mit der Versorgungsspannungsklemme $U_{DD}$ verschaltet. Der Emitter des Transistors T4 ist über die Stromquelle I8 mit der Versorgungsspannungsklemme $U_{DD}$ verbunden. Der Kollektor des Transistors T4 ist mit der Basis und dem Kollektor des npn-Transistors T1 verbunden, dessen Emitter mit Masse verschaltet ist. Die Basis des Transistors T1 ist mit der Basis des npn-Transistors T2 verschaltet, dessen Emitter ebenfalls mit Masse verbunden ist. Der Kollektor des Transistors T2 ist zum einen mit dem Gateanschluß des Transistors M2 und zum anderen über die Stromquelle I6 mit der Versorgungsspannungsklemme $U_{DD}$ verbunden. Der Sourceanschluß des Transistors M2 ist mit Masse verschaltet und der Drainanschluß bildet den Ausgang des Komparators und dieser ist über die Stromquelle I5 ebenfalls mit der Versorgungsspannungsklemme $U_{DD}$ verbunden. Der Drainanschluß des Transistors M2 ist mit den Gateanschlüssen der Transistoren M3 und M4 verschaltet.

Ist das Steuersignal St logisch „1", so wird das Gate des Transistors M1 von der Stromquelle I4 entladen und der Treiber ausgeschaltet. Gleichzeitig erfolgt eine Aufladung des Kondensators $C_H$ durch die Stromquelle I3 über die Diode D1. In diesem Zustand ist sowohl der Transistor M3 wie auch der Transistor M4 gesperrt.

Die Aktivierung dieser Ansteuerschaltung erfolgt nun durch ein logisches „0" des Steuersignals St. Dadurch werden die Stromquellen I3 und I4 abgeschaltet und die Gate-Source-Kapazität (in Figur 2 nicht dargestellt) von M1 wird über den Lastwiderstand $R_L$ und die Stromquelle I9 sowie die Diode D2 aufgeladen und das Gate-Potential $U_G$ steigt an. Der Ausgangstransistor M1 befindet sich im Sättigungsbereich und sein Drainstrom nimmt zu.

Wenn $U_G$ etwa zwei Basis-Emitterspannungen unter der positiven Betriebsspannung $U_{DD}$ liegt, reißen die Kollektorströme der Transistoren T3 und T4 ab, womit das Gate des Transistors M2 durch den Stromspiegel, welcher durch die Transistoren T1, T2 gebildet wird, nicht mehr nach unten gezogen werden kann. Daraufhin öffnet der Transistor M2 und entlädt die Gates der Transistoren M3 und M4. Mit M3 wird der auf etwa Betriebsspannung vorgeladene Kondensator $C_H$ vorzeichenrichtig an $U_{DD}$ gelegt. Die resultierende Spannungsüberhöhung bewirkt einen Ladungsausgleich über den Transistor M4 zur Gate-Source-Kapazität von M1. $U_{GS}$(M1) steigt an und der Leistungstransistor gelangt in den linearen Arbeitsbereich.

Entgegen der prinzipiellen Darstellung in Figur 1, bei welcher der Spannungshub am Lastwiderstand ausgenützt wird, wird in dieser Schaltung der Spannungssprung durch das Einschalten des Transistors M3 erzeugt. Neben der höheren Schaltgeschwindigkeit hat das den Vorteil, daß dieser zu einem definierten Zeitpunkt erfolgt und so nicht zu einem vorzeitigen Öffnen des Transistors M4 über die Sourcesteuerung führen kann.

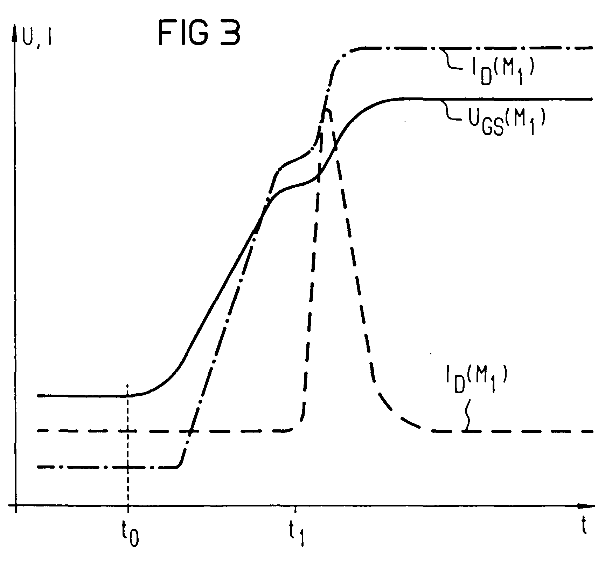

Figur 3 zeigt den Ausgleichsstrom, d.h. den Drainstrom des Transistors M4, die Gatespannung des Leistungstransistors M1 und den Laststrom, d.h. den Drainstrom von Transistor M1, während des Einschaltens über die Zeit. Der Transistor M1 besteht aus z.B. 600 parallel geschalteten Zellen. Bei der Betriebsspannung von z.B. $U_{DD} = 12\,V$, $C_H = 20\,pF$ und einem Lastwiderstand von z.B. $R_L = 100\,\Omega$ wird bei $t_0$ die Treiberschaltung eingeschaltet. Zum Zeitpunkt $t_1$, d.h. ungefähr 3 $\mu$sec später, wird der Transistor M4 aktiviert und der freigegebene Ladungsimpuls bewirkt ein Ansteigen der Gatespannung um $\Delta U_G$ ungefähr gleich 4 V.

Die erfindungsgemäße Schaltung funktioniert prinzipiell nur dynamisch. Wird ein statisches Einschalten gefordert, so kann eine kleine Ladungspumpe, die erst später zugeschaltet wird, verhindern, daß sich die Gates der Leistungstransistoren über Diodenreststöme entladen.

**Patentansprüche**

1. Schaltungsanordnung zum Ansteuern eines Feldeffekttransistors, über dessen Laststrecke eine Last sourceseitig mit einer Versorgungsspannung beaufschlagt wird, mit einem Kondensator, der mit einer ersten Ladeeinrichtung sowie ersten steuerbaren Schaltmitteln verbunden ist, wobei die ersten Schaltmittel den ersten Anschluß des Kondensators mit dem Gateanschluß des Feldeffekttransistors verbinden,
   **dadurch gekennzeichnet,** daß eine zweite Ladeeinrichtung (I2, D2) vorgesehen ist, die über zweite steuerbare Schaltmittel (S1) die Gate-Source-Kapazität ($C_{GS}$) des Feldeffekttransistors (M1) auflädt, und daß ein Komparator (OP) vorgesehen ist, der die Spannung am Gate des Feldeffekttransistors (M1) überwacht und bei Erreichen eines vorbestimmten Werts die ersten Schaltmittel (S2) leitend ansteuert.

2. Schaltungsanordnung nach Anspruch 1,
   **dadurch gekennzeichnet,** daß die zweite Ladeeinrichtung und die zweiten steuerbaren Schaltmittel durch die Reihenschaltung einer steuerbaren Stromquelle (I9) und einer in Flußrichtung geschalteten Diode (D2) gebildet werden.

3. Schaltungsanordnung nach einem der vorhergehenden Ansprüche,
   **dadurch gekennzeichnet,** daß eine zweite steuerbare Stromquelle (I4) vorgesehen ist, die zwischen Gate des Feldeffekttransistors (M1) und Masse geschaltet ist und mit einem zur zweiten Ladeeinrichtung invertierten Steuersignal angesteuert wird.

4. Schaltungsanordnung nach einem der vorhergehenden Ansprüche,
   **dadurch gekennzeichnet,** daß der Komparator einen Spannungs-Stromwandler (I7, T3) und eine daran angekoppelte Stromspiegelschaltung (T1, T2, T4, I6, I8) enthält.

5. Schaltungsanordnung nach einem der vorhergehenden Ansprüche,
   **dadurch gekennzeichnet,** daß der zweite Anschluß des Kondensators ($C_H$) über dritte Schaltmittel (M3) mit der Versorgungsspannung verbunden ist, wobei die Schaltmittel (M3) in Abhängigkeit vom Ausgangssignal des Komparators (T1 bis T4, I6 bis I8, M2) geschaltet werden.

6. Schaltungsanordnung nach Anspruch 5,
   **dadurch gekennzeichnet,** daß zwischen dem zweiten Anschluß des Kondensators ($C_H$) und Masse eine dritte steuerbare Stromquelle (I3) geschaltet ist, die mit dem zur zweiten Ladeeinrichtung invertierten Steuersignal angesteuert wird, und daß zwischen dem ersten Anschluß des Kondensators ($C_H$) und der Versorgungsspannung eine Diode (D1) geschaltet ist, die zusammen mit der dritten steuerbaren (I3) Stromquelle die erste Ladeeinrichtung bildet.

7. Schaltungsanordnung nach einem der vorhergehenden Ansprüche,
   **dadurch gekennzeichnet,** daß eine Ladungspumpe vorgesehen ist, deren Ausgangsspannung mit dem ersten Anschluß des Kondensators ($C_H$) verbunden ist.

FIG 1

FIG 2

FIG 3

$I_D(M_1)$

$U_{GS}(M_1)$

$I_D(M_1)$

$t_0$      $t_1$      t

U, I